(19) Europäisches Patentamt
European Patent Office
Office européen des brevets

(11) EP 4 006 578 A1

(12) # EUROPEAN PATENT APPLICATION
published in accordance with Art. 153(4) EPC

(43) Date of publication:
**01.06.2022 Bulletin 2022/22**

(21) Application number: **20847342.1**

(22) Date of filing: **17.06.2020**

(51) International Patent Classification (IPC):
***G01S 7/4861*** *(2020.01)* ***G01C 3/06*** *(2006.01)*
***G01S 17/10*** *(2020.01)* ***H01L 27/146*** *(2006.01)*
***H04N 5/345*** *(2011.01)*

(52) Cooperative Patent Classification (CPC):
**G01C 3/06; G01S 7/4861; G01S 17/10; H01L 27/146; H04N 5/345**

(86) International application number:
**PCT/JP2020/023703**

(87) International publication number:
**WO 2021/019939 (04.02.2021 Gazette 2021/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.07.2019 JP 2019137656**

(71) Applicant: **Sony Semiconductor Solutions Corporation**
**Atsugi-shi Kanagawa 243-0014 (JP)**

(72) Inventors:
- **SONODA, Yuuko**
**Atsugi-shi, Kanagawa 243-0014 (JP)**
- **MAHARA, Kumiko**
**Atsugi-shi, Kanagawa 243-0014 (JP)**

(74) Representative: **Müller Hoffmann & Partner**
**Patentanwälte mbB**
**St.-Martin-Strasse 58**
**81541 München (DE)**

(54) **LIGHT RECEIVING DEVICE, METHOD FOR CONTROLLING LIGHT RECEIVING DEVICE, AND DISTANCE-MEASURING DEVICE**

(57) A light reception device of the present disclosure includes: a light-receiving section including pixels two-dimensionally arranged in a matrix, the pixels each including a light-receiving element; a row selector that selects the pixels of the light-receiving section in units of one pixel row or a plurality of pixel rows; a column selector that selects the pixels in one pixel row or a plurality of pixel rows selected by the row selector in pixel units; and a controller that controls the column selector. Then, the controller controls the column selector to select the pixels in the one pixel row or the plurality of pixel rows selected by the row selector in units of regions each including a plurality of pixels as a unit, and read out signals of the pixels for each of the regions. In addition, a distance measuring device of the present disclosure uses a light reception device having a configuration described above.

EP 4 006 578 A1

[ FIG. 5 ]

FIG. 5

30
40
S_SYNC
LD_NUM
TRG_I
PRE_TRG
SEL
CONTROLLER
60
50
EN_SPAD_H198[2:0]
EN_SPAD_H1[2:0]
EN_SPAD_H0[2:0]
COLUMN SELECTOR
ROW DIRECTION
COLUMN DIRECTION
READOUT CIRCUIT SECTION
80
90
70
ROW SELECTOR
V CONTROL SIGNAL 062[2:0]
V CONTROL SIGNAL 001[2:0]
V CONTROL SIGNAL 000[2:0]

**Description**

Technical Field

The present disclosure relates to a light reception device, a method of controlling a light reception device, and a distance measuring device (a distance measurement device).

Background Art

There is a light reception device using, as a light-receiving element, an element that generates a signal in response to reception of a photon (see PTL 1, for example). In a light reception device of this kind, as a measurement method for measuring a distance to a measurement object, a ToF (Time Of Flight) method is adopted which measures a time until light emitted toward the measurement object returns after being reflected by the measurement object.

Citation List

Patent Literature

PTL 1: Japanese Unexamined Patent Application Publication No. 2016-211881

Summary of the Invention

Problem to be Solved by the Invention

Of the ToF, a direct ToF method directly calculates a distance from a time-of-flight difference of light. In the direct ToF method, processing of reading out a signal of each pixel of a light-receiving section is performed. The light-receiving section includes pixels that each include a light-receiving element and are two-dimensionally arranged in a matrix. On this occasion, in a case where one pixel row or a plurality of pixel rows of the pixels of the light-receiving section are selected as a unit, and signals of all the pixels in a thus-selected region are read out at once, power consumption is increased.

Therefore, an object of the present disclosure is to provide a light reception device and a method of controlling a light reception device that make it possible to reduce power consumption in reading out a signal of each of pixels in a light-receiving section, and a distance measuring device that uses the light reception device.

Means for Solving the Problem

A light reception device of the present disclosure to achieve the above-described object includes:

a light-receiving section including pixels two-dimensionally arranged in a matrix, the pixels each including a light-receiving element;
a row selector that selects the pixels of the light-receiving section in units of one pixel row or a plurality of pixel rows;
a column selector that selects the pixels in one pixel row or a plurality of pixel rows selected by the row selector in pixel units; and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

A method of controlling a light reception device of the present disclosure to achieve the above-described object, the light reception device including

a light-receiving section including pixels two-dimensionally arranged in a matrix, the pixels each including a light-receiving element,
a row selector that selects the pixels of the light-receiving section in units of one pixel row or a plurality of pixel rows, and
a column selector that selects the pixels in one pixel row or a plurality of pixel rows selected by the row selector in pixel units,
the method including:
in control of the light reception device, controlling the column selector to select the pixels in the one pixel row or the plurality of pixel rows selected by the row selector in units of regions each including a plurality of pixels as a unit, and reading out signals of the pixels for each of the regions.

A distance measuring device of the present disclosure to achieve the above-described object includes:

a light source that irradiates a measurement object with light; and
a light reception device that detects light reflected by the measurement object, the light reception device including:

a light-receiving section including pixels two-dimensionally arranged in a matrix, the pixels each including a light-receiving element,
a row selector that selects the pixels of the light-receiving section in units of one pixel row or a plurality of pixel rows,
a column selector that selects the pixels in one pixel row or a plurality of pixel rows selected by the row selector in pixel units, and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

Brief Description of the Drawings

[FIG. 1] FIG. 1 is a schematic configuration diagram illustrating an example of a distance measuring device according to an embodiment of the present disclosure.
[FIG. 2] FIG. 2A and FIG. 2B are block diagrams each illustrating an example of a specific configuration of the distance measuring device according to the embodiment of the present disclosure.
[FIG. 3] FIG. 3 is a circuit diagram illustrating an example of a basic pixel circuit using an SPAD element.
[FIG. 4] FIG. 4A is a characteristic diagram illustrating current-voltage characteristics of a PN junction of the SPAD element, and FIG. 4B is a waveform diagram for description of a circuit operation of the pixel circuit.
[FIG. 5] FIG. 5 is a schematic configuration diagram illustrating an example of a light reception device according to an embodiment of the present disclosure.
[FIG. 6] FIG. 6 is a flowchart that describes a method of controlling the light reception device according to the embodiment of the present disclosure.
[FIG. 7] FIG. 7 is a circuit diagram illustrating an example of a configuration of a pixel circuit according to an example 1.
[FIG. 8] FIG. 8 is a schematic configuration diagram illustrating an example of a configuration of a readout circuit section according to an example 2.
[FIG. 9] FIG. 9A is a diagram illustrating a correspondence between a control signal LD_NUM and the division number in a control example according to an example 3, and
FIG. 9B is a diagram illustrating an operation image when LD_NUM = 1, that is, when the division number = 2.
[FIG. 10] FIG. 10A is a diagram illustrating an example of setting of the division number of regions ROI by the control signal LD_NUM and specification of the region ROI by a selection signal SEL, and FIG. 10B is a diagram illustrating an example in which the region ROI is specified only by the selection signal SEL.
[FIG. 11] FIG. 11 is a diagram illustrating an operation example of time-division readout according to an example 4 in a case of division into four.
[FIG. 12] FIG. 12 is a diagram that describes a malfunction in a case where adjacent regions are set as readout regions in order.
[FIG. 13] FIG. 13 is a diagram illustrating an operation example of time-division readout in a case of division into five.
[FIG. 14] FIG. 14A and FIG. 14B are waveform diagrams that each describe a specific example of peak selection of a histogram according to an example 5.
[FIG. 15] FIG. 15 is a block diagram illustrating an example of a schematic configuration of a vehicle control system that is an example of a mobile body control system to which the technology according to the present disclosure is applicable.
[FIG. 16] FIG. 16 is a diagram illustrating an example of an installation position of the distance measuring device.

Modes for Carrying Out the Invention

Hereinafter, modes for carrying out the technology of the present disclosure (hereinafter referred to as "embodiments") are described in detail with reference to the drawings. The technology of the present disclosure is not limited to the embodiments, and various numerical values and the like in the embodiments are illustrative. In the following description, the same components, or components having the same function are denoted by the same reference signs, and redundant description is omitted. It is to be noted that description is given in the following order.

1. General Description of Light Reception Device and Distance Measuring Device of Present Disclosure
2. Distance Measuring device According to Embodiment
    - 2-1. Specific Configuration Example of Distance Measuring Device
    - 2-2. Basic Pixel Circuit Example Using SPAD Element
    - 2-3. Circuit Operation Example of Pixel Circuit Using SPAD Element
3. Light Reception Device According to Embodiment
    - 3-1. Example 1 (A configuration example of a pixel circuit)
    - 3-2. Example 2 (A configuration example of a readout circuit section)
    - 3-3. Example 3 (A control example by a controller)
    - 3-4. Example 4 (An example in which signals of regions ROI are read out in a time division manner)
    - 3-5. Example 5 (An example in which a peak of a histogram is selected)
4. Modification Examples
5. Application Example of Technology According to Present Disclosure (An example of a mobile body)
6. Possible Configurations of Present Disclosure

<General Description of Light Reception Device and Distance Measuring Device of Present Disclosure>

A light reception device and a distance measuring device of the present disclosure may have a configuration including a readout circuit section that processes a signal read out from each of pixels of a light-receiving section. Then, the readout circuit section may be configured to process signals read out from the pixels of the light-receiving section for each region selected by a column selector. In addition, a controller may be configured to control the readout circuit section to turn a circuit portion other than a circuit portion corresponding to the region selected by the column selector to an inactivated state.

The light reception device and the distance measuring device of the present disclosure including the preferred configurations described above may have a configuration in which the pixels each include a column selection switch element that turns each pixel to a selected state in response to a scanning signal supplied from the column selector. In addition, the column selection switch element may be configured to turn the pixel to an unselected state by turning power to the pixel to a shutoff state.

In addition, in the light reception device and the distance measuring device of the present disclosure including the preferred configurations described above, the controller may be configured to be able to set the number of regions each including a plurality of pixels as a unit in one pixel row or a plurality of pixel rows selected by the row selector. Furthermore, the controller may be configured to be able to optionally specify a region where signals of pixels are to be read out, among a plurality of set regions.

In addition, in the light reception device and the distance measuring device of the present disclosure including the preferred configurations described above, the controller may be configured to set, as a present readout region, a region away from a previous readout region in a case where the signals of the pixels in the one pixel row or the plurality of pixel rows selected by the row selector are read out in a time division manner for each region.

In addition, in the light reception device and the distance measuring device of the present disclosure including the preferred configurations described above, the light-receiving element may be configured to include an element that generates a signal in response to reception of a photon, and preferably a single-photon avalanche diode.

< Distance Measuring Device According to Embodiment>

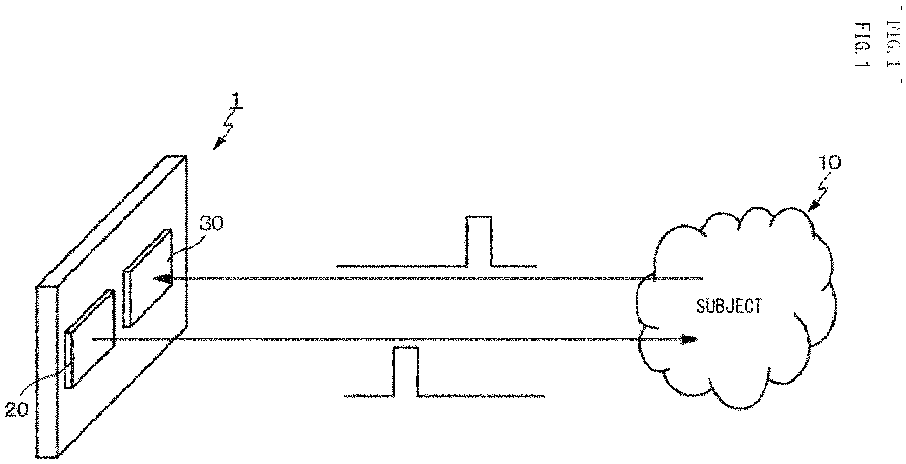

FIG. 1 is a schematic configuration diagram illustrating an example of a distance measuring device according to an embodiment of the present disclosure. A distance measuring device 1 according to the present embodiment adopts, as a measurement method for measuring a distance to a subject 10 that is a measurement object, a ToF method that measures a time of flight until light (e.g., laser light having a peak wavelength in an infrared wavelength region) emitted toward the subject 10 returns by being reflected by the subject 10. In order to implement distance measurement by the ToF, the distance measuring device 1 according to the present embodiment includes a light source 20 and a light reception device 30. Furthermore, as the light reception device 30, it is possible to use a light reception device according to an embodiment of the present disclosure to be described later.

[Specific Configuration Example of Distance Measuring Device]

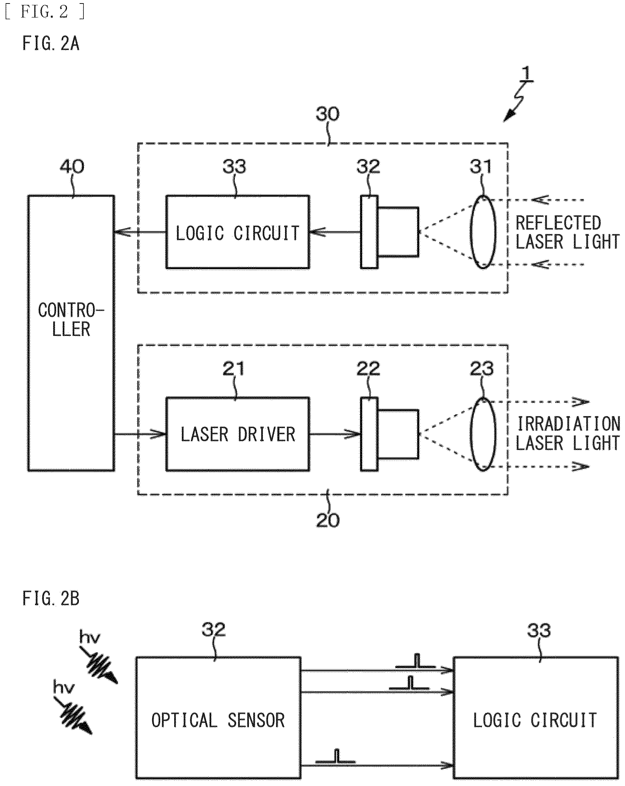

FIG. 2A and FIG. 2B each illustrate an example of a specific configuration of the distance measuring device 1 according to the present embodiment. The light source 20 includes, for example, a laser driver 21, a laser light source 22, and a diffusion lens 23, and irradiates the subject 10 with laser light. The laser driver 21 drives the laser light source 22 under control by the controller 40. The laser light source 22 includes, for example, a laser diode, and is driven by the laser driver 21 to emit laser light. The diffusion lens 23 diffuses the laser light emitted from the laser light source 22 to irradiate the subject 10 with the laser light.
The light reception device 30 includes a light-receiving lens 31, an optical sensor 32 that is a light-receiving section, and a logic circuit 33, and receives reflected laser light. The reflected laser light is irradiation laser light by a laser irradiation section 20 that returns by being reflected by the subject 10. The light-receiving lens 31 condenses the reflected laser light from the subject 10 onto a light-receiving surface of the optical sensor 32. The optical sensor 32 receives the reflected laser light from the subject 10 having passed through the light-receiving lens 31 in pixel units and performs photoelectric conversion of the reflected laser light. As the optical sensor 32, it is possible to use a two-dimensional array sensor (a so-called area sensor) including pixels that each include a light-receiving element and are two-dimensionally arranged in a matrix (in an array).
An output signal of the optical sensor 32 is supplied to the controller 40 via the logic circuit 33. The controller 40 includes, for example, a CPU (Central Processing Unit) or the like. The controller 40 controls the light source 20 and the light reception device 30, and measures a time t until laser light emitted from the light source 20 toward the subject 10 returns by being reflected by the subject 10. It is possible to determine a distance L to the subject 10 on the basis of the time t.
As a time measurement method, a timer starts at a timing at which the light source 20 emits pulsed light, and stops the timer at a timing at which the light reception device 30 receives the pulsed light, thereby measuring the time t. As another time measurement method, the light source 20 may emit pulsed light at predetermined intervals, and the light reception device 30 may detect intervals at which the pulsed light is received, thereby measuring the time t from a phase difference between intervals at which light is emitted and intervals at which light is received. The time is measured by executing time measurement a plurality of times and detecting a peak of a histogram in which times obtained by the plurality of times of measurement are cumulated.
Then, in the present embodiment, a sensor including, as the light-receiving element of the pixel, an element that generates a signal in response to reception of a photon, for example, an SPAD (Single Photon Avalanche Diode: single-photon avalanche diode) element is used as the optical sensor 32. That is, the light reception device 30 according to the present embodiment has a configuration in which the light-receiving element of the pixel includes an SPAD element. It is to be noted that the light-receiving element is not limited to the SPAD element, and may include any of various elements such as an APD (Avalanche Photo Diode) and a CAPD (Current Assisted Photonic Demodulator).

[Basic Pixel Circuit Example Using SPAD Element]

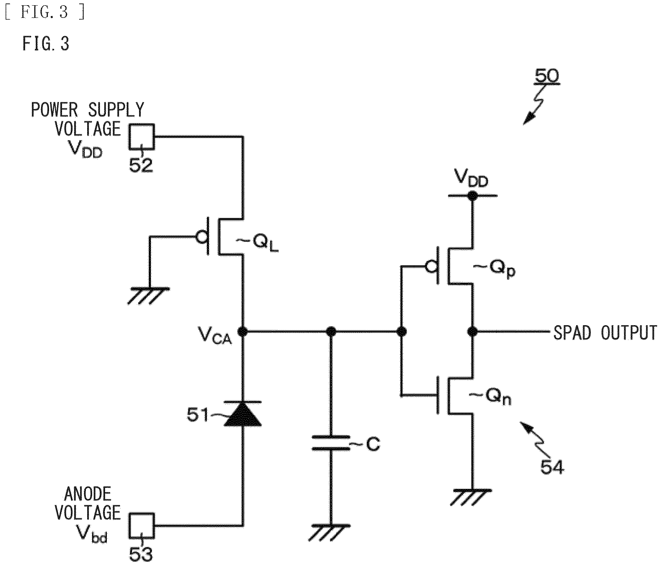

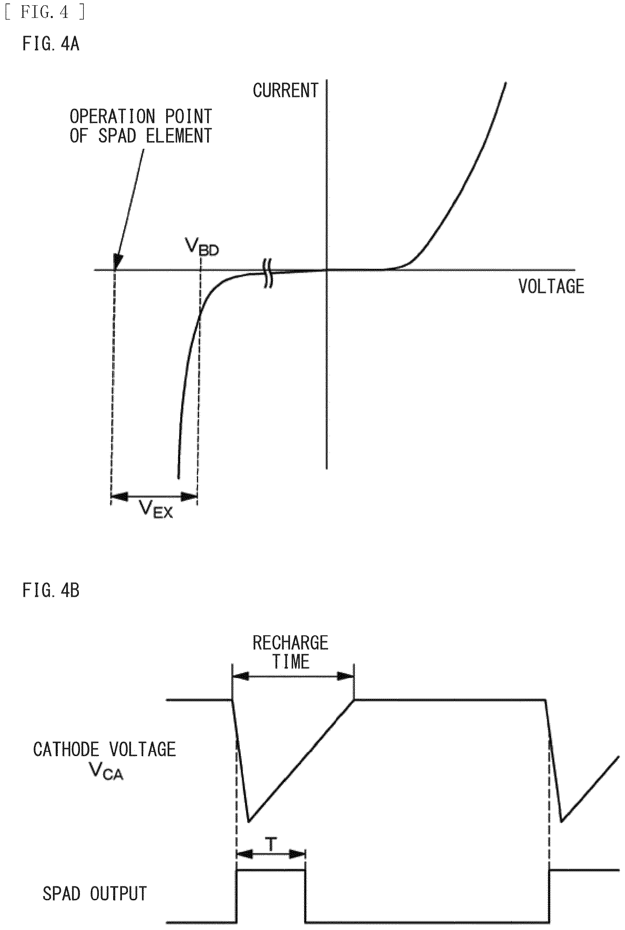

FIG. 3 illustrates an example of a basic pixel circuit in the light reception device 30 using the SPAD element. Here, a basic configuration of one pixel is illustrated.
A basic pixel circuit of a pixel 50 using an SPAD element has a configuration in which a SPAD element 51 has a cathode electrode coupled to a terminal 52 supplied with a power supply voltage $V_{DD}$ via a P-type MOS transistor $Q_L$ that is a load, and an anode electrode coupled to a terminal 53 supplied with an anode voltage $V_{bd}$. As the anode voltage $V_{bd}$, a large negative voltage that causes avalanche multiplication is applied. A capacitive element C is coupled between the anode electrode and a ground. Then, the cathode voltage $V_{CA}$ of the SPAD element 51 is derived as an SPAD output (a pixel output) via a CMOS inverter 54 including a P-type MOS transistor $Q_p$ and an N-type MOS transistor $Q_n$ that are coupled in series to each other.
A voltage equal to or higher than a breakdown voltage $V_{BD}$ is applied to the SPAD element 51. An excess voltage equal to or higher than the breakdown voltage $V_{BD}$ is called an excess bias voltage $V_{EX}$, and is generally about a voltage of 2 V to 5 V. The SPAD element 51 operates in a region called Geiger mode in which there is no DC steady point. FIG. 4A illustrates I (current)-V (voltage) characteristics of a PN junction of the SPAD element 51.

[Circuit Operation Example of Pixel Circuit Using SPAD Element]

Next, description is given of an example of a circuit operation of the pixel circuit having the configuration described above with reference to a waveform diagram in FIG. 4B.
In a state in which a current does not pass through the SPAD element 51, a voltage having a value of $V_{DD}$ -

$V_{bd}$ is applied to the SPAD element 51. This voltage value ($V_{DD}$ - $V_{bd}$) is ($V_{BD}$ + $V_{EX}$). Then, a dark electron generation rate DCR (Dark Count Rate) and electrons generated by the light irradiation cause avalanche multiplication at a PN junction section of the SPAD element 51, thereby generating an avalanche current. Such a phenomenon occurs stochastically even in a light-shielded state (that is, in a state in which no light is incident). This is the dark electron generation rate DCR.

In a case where the cathode voltage $V_{CA}$ decreases and a voltage between terminals of the SPAD element 51 becomes the breakdown voltage $V_{BD}$ of a PN diode, the avalanche current stops. Then, electrons generated and accumulated by the avalanche multiplication are discharged by a resistive element R (or the P-type MOS transistor $Q_L$) that is a load, and the cathode voltage $V_{CA}$ recovers to the power supply voltage $V_{DD}$, and returns to an initial state.

In a case where light is incident on the SPAD element 51 and at least one pair of an electron and a hole is generated, the pair causes generation of an avalanche current. Thus, it is possible to detect even incidence of one photon at a certain detection efficiency PDE (photon detection efficiency). The detection efficiency PDE at which this photon is detectable is generally about several % to about 20%.

The above-described operations are repeated. In addition, in this series of operations, the cathode voltage $V_{CA}$ is waveform-shaped by the CMOS inverter 54, and a pulse signal having a pulse width T with the arrival time of one photon as a start point is the SPAD output (pixel output).

<Light Reception Device According to Embodiment>

Next, description is given of the light reception device according to the embodiment of the present disclosure that may be used in the distance measuring device 1 having the configuration described above, and a method of controlling the light reception device. The light reception device according to the present embodiment includes a light-receiving section including the pixels 50 having the configuration described above that are two-dimensionally arranged in a matrix. It can be said that the light-receiving section including the two-dimensionally arranged pixels 50 corresponds to the optical sensor 32 in FIG. 2A.

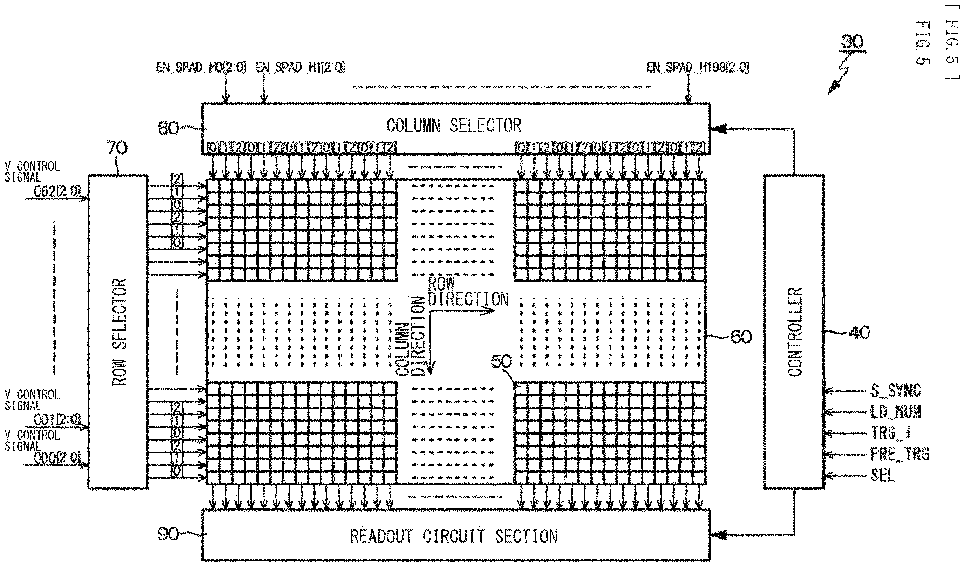

FIG. 5 is a schematic configuration diagram illustrating an example of the light reception device according to the embodiment of the present disclosure. As illustrated in FIG. 5, the light reception device 30 according to the present embodiment includes a light-receiving section 60 including the pixels 50. The pixels 50 each include, as a light-receiving element, an element that generates a signal in response to reception of a photon, for example, the SPSD element 51, and are two-dimensionally arranged in a matrix. The light reception device 30 according to the present embodiment has a system configuration including a row selector 70, a column selector 80, a readout circuit section 90, a controller 40, and the like in addition to the light-receiving section 60.

The row selector 70 selects, as a unit, one pixel row or a plurality of pixel rows of the pixels 50 of the light-receiving section 50 on the basis of a V control signal supplied from outside of the light reception device 30. Here, a case where V control signals 000[2:0] to 062[2:0] are used as the V control signal is exemplified. The column selector 80 selects the pixels 50 of the light-receiving section 60 in pixel units on the basis of an H control signal supplied from outside of the light reception device 30. Here, a case where H control signals EN_SPAD_H0[2:0] to EN_SPAD_H198[2:0] are used as the H control signal.

The readout circuit section 90 reads out signals of the pixels 50 selected in pixel units by the column selector 80 in the one pixel row or the plurality of pixel rows selected by the row selector 70, and performs predetermined processing on the signals, and thereafter outputs the signals to outside of the light reception device 30. The controller 40 performs control of pixel selection by the column selector 80, and readout control of the signals (pixel signals) of the pixels 50 by the readout circuit section 90 on the basis of a synchronization signal S_SYNC, a control signal LD_NUM, timing signals TRG_I and PRE_TRG, and the selection signal SEL supplied from outside of the light reception device 30.

In the light reception device 30 according to the present embodiment having the configuration described above, in a case where one pixel row or a plurality of pixel rows of the pixels 50 of the light-receiving section 60 are selected as a unit, and signals of all the pixels in a thus-selected region are read out at once, all the pixels in the selected pixel row or rows are simultaneously driven to increase a peak current. Furthermore, in addition to simultaneously driving all the pixels in the selected pixel row or rows, even in the readout circuit section that processes the read pixel signals, all circuit portions corresponding to all the pixels perform a processing operation. As a result, power consumption is increased.

Accordingly, in the light reception device 30 according to the present embodiment, the signals 50 of the pixels in a pixel row (one pixel row or a plurality of pixel rows) selected by the row selector 70 are read out in a time division manner for each region including a plurality of pixels as a unit. Specifically, the column selector 80 selects a plurality of pixels as a unit from the pixels 50 in the pixel row selected by the row selector 70 under control by the controller 40. Then, the readout circuit section 90 reads out the signals of the pixels 50 in a time division manner for each region including, as a unit, the plurality of pixels selected by the column selector 80 under control by the controller 40.

More specifically, control lines in a row direction (an H direction) are divided for each pixel 50, which makes it possible to freely perform switching ON/OFF in pixel units by the column selector 80. Then, switching ON/OFF in pixel units by the column selector 80 is performed by control based on the H control signal supplied from outside to select a plurality of pixels as a unit. Then, signals of the pixels 50 in regions each including, as a unit, the plurality of pixels are read out in a time division manner.

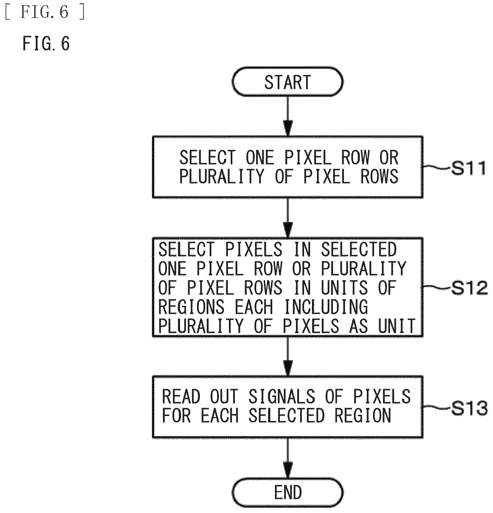

Next, description is given of a method of controlling the light reception device 30 according to the present embodiment to be executed under control by the controller 40 with reference to a flowchart in FIG. 6. The controller 40 controls the row selector 70 to select, as a unit, one pixel row or a plurality of pixel rows of the pixels 50 of the light-receiving section 60 (step S11). Next, the column selector 80 is controlled to select the pixels 50 in the selected pixel row or rows in units of regions each including, as a unit, a plurality of pixels (step S12). Then, the controller 40 controls the readout circuit section 90 to read out the signals of the pixels 50 in a time division manner for each selected region (step S13).

As described above, in the light reception device 30 according to the present embodiment, for the signals of the pixels 50 in a pixel row (one pixel row or a plurality of pixel rows) selected by the row selector 70, readout of pixel signals is performed in a time division manner for each region including, as a unit, a plurality of pixels. Performing readout of the pixel signals in a time division manner for each region selected by the column selector 80 in such a manner makes it possible to reduce power consumption, as compared with a case where signals of all pixels in one pixel row or a plurality of pixel rows are read out at once.

The following description is given of specific examples of the present embodiment for performing readout of pixel signals in a time division manner for each region including, as a unit, a plurality of pixels in order to achieve reduction in power consumption.

[Example 1]

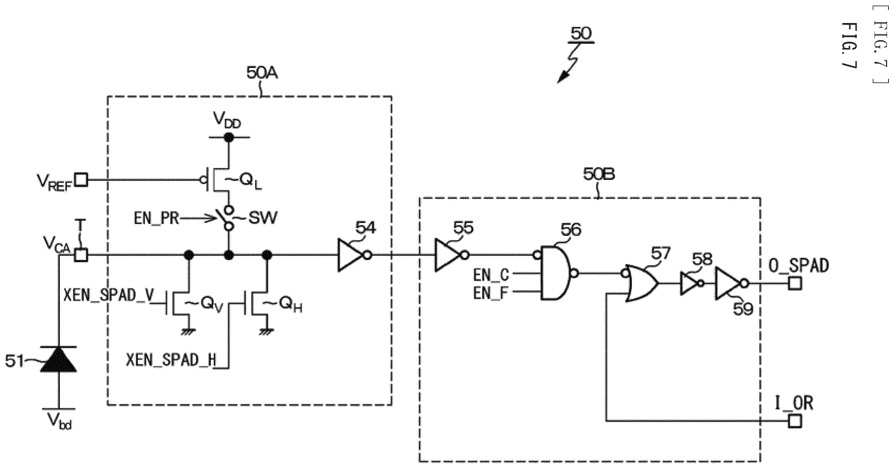

An example 1 is a circuit example (a pixel circuit example) of the pixel 50 used in the light reception device 30 according to the embodiment of the present disclosure. FIG. 7 illustrates an example of a configuration of a pixel circuit according to the example 1.

The pixel 50 according to the example 1 includes a first circuit section 50A and a second circuit section 50B. The first circuit section 50A includes a switch element SW and two N-type MOS transistors $Q_V$ and $Q_H$, in addition to the P-type MOS transistor $Q_L$ (a load) and the CMOS inverter 54 in a basic pixel circuit illustrated in FIG. 3. The CMOS inverter 54 is a CMOS inverter including the P-type MOS transistor $Q_p$ and the N-type MOS transistor $Q_n$ in FIG. 3 that are coupled in series to each other.

The switch element SW is a quench switch, and stops an avalanche phenomenon by lowering a voltage applied to the SPAD sensor 51 to a breakdown voltage by a quenching operation.

Each of the two N-type MOS transistors $Q_V$ and $Q_H$ is coupled between a terminal T coupled to the cathode electrode of the SPAD element 51 and a reference potential node (e.g., a ground GND). One N-type MOS transistor $Q_V$ is a row selection switch element for selecting the pixels 50 in pixel row units. The other N-type MOS transistor $Q_H$ is a column selection switch element for selecting the pixels 50 in pixel column units.

The N-type MOS transistor $Q_V$ for row selection is turned to a non-conduction state in response to a scanning signal XEN_SPAD_V supplied from the row selector 70 in FIG. 5 to turn the terminal T to an open state, thereby selecting the pixels 50 in pixel row units. The N-type MOS transistor $Q_H$ for column selection is turned to the non-conduction state in response to a scanning signal XEN_SPAD_H supplied from the column selector 80 in FIG. 5 to turn the terminal T to the open state, thereby selecting the pixels 50 in pixel column units.

Providing the N-type MOS transistor $Q_H$ for column selection makes it possible to select, in pixel units, the pixels 50 in one pixel row or a plurality of pixel rows selected by the row selector 70. In addition, the N-type MOS transistor $Q_H$ for column selection is turned to a conduction state to turn a potential of the terminal T to a ground potential, thereby powering off the pixel 50 to turn the pixel 50 to a unselected state. In an unselected pixel, power to the pixel 50 is turned to a shutoff state by an action of the N-type MOS transistor $Q_H$ makes it possible to achieve reduction in power consumption.

The second circuit section 50B of the pixel 50 according to the example 1 has a circuit configuration including a level shift circuit 55, an 3-input NAND circuit 56, a 2-input OR circuit 57, an inverter circuit 58, and an inverter circuit 59.

The voltage $V_{CA}$ of the terminal T passes through the CMOS inverter 54, and thereafter is level shifted by the level shift circuit 55 to become an inversion input (a firs input) of the 3-input NAND circuit 56. In the 3-input NAND circuit 56, a control signal EN_C and a control signal EN_F are a second input and a third input. The control signal EN_C is a signal for control in a column direction (a vertical direction). The control signal EN_F is a signal for control of the row direction (a horizontal direction). A gate of the NAND circuit 56 opens when both the control signal EN_C and the control signal EN_F are logic "1".

An output of the NAND circuit 56 is an inversion input (a first input) of the 2-input OR circuit 57. In the 2-input OR circuit 57, a control signal I_OR supplied from outside of the pixel 50, for example, the controller 40 in FIG. 5 is a second input. The control signal I_OR is a signal for controlling whether to enable or disable readout of the signal of the pixel 50. An output of the OR circuit 57 is outputted as a pixel signal O_SPAD via the inverter circuit 58 and the inverter circuit 59.

As described above, the pixel circuit according to the example 1 has a configuration including the column selection switch element that turns each pixel to a selected state in response to the scanning signal XEN_SPAD_H supplied from the column selector 80, that is, the N-type MOS transistor $Q_H$. This makes it possible to select the pixels 50 in one pixel row or a plurality of pixel rows selected by the row selector 70 in units of regions each including, as a unit, a plurality of pixels, and read out the signals of pixels for each region. In addition, as for an unselected pixel, power to the pixel 50 is turned to the shutoff state by an action of the N-type MOS transistor $Q_H$, which makes it possible to achieve power saving.

[Example 2]

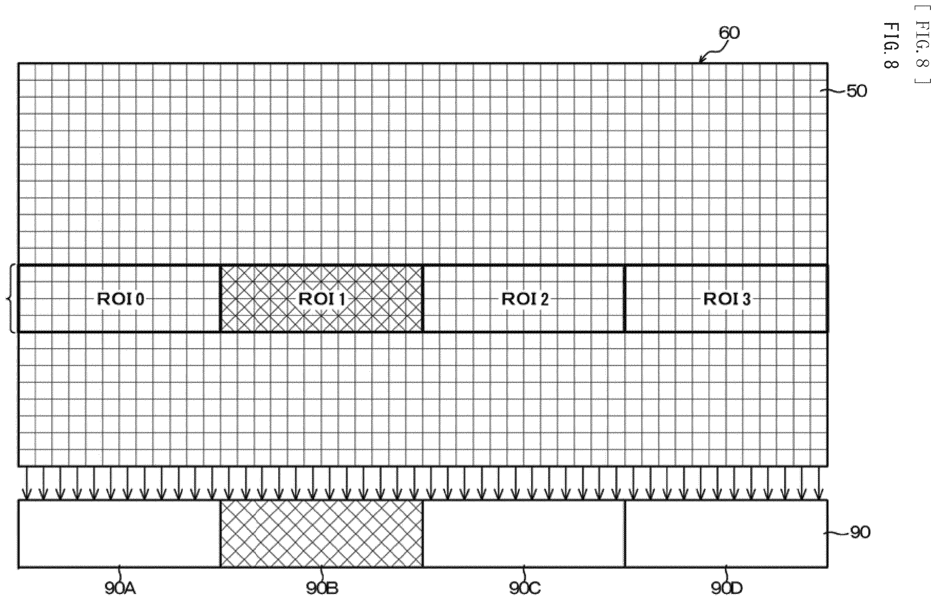

An example 2 is a configuration example of the readout circuit section 90 used in the light reception device 30 according to the embodiment of the present disclosure. FIG. 8 illustrates an example of a configuration of the readout circuit section 90 according to the example 2.

Here, for simplification of the drawing, the light-receiving section 60 having a 48 horizontal × 24 vertical pixel arrangement is illustrated as an example. For example, each of control lines where a horizontal scanning signal XEN_SPAD_H, a vertical scanning signal XEN_SPAD_V, and a control signal EN_C are transmitted is wired for each pixel to the 48 horizontal × 24 vertical pixel arrangement, and each of control lines where a control signal EN_F is transmitted is wired for every three pixels to the 48 horizontal × 24 vertical pixel arrangement. These control signals are not illustrated for simplification of the drawing.

In the present example, for ease of understanding, the row selector 70 selects the pixels 50 of the light-receiving section 60, for example, in units of four pixel rows in the 48 horizontal × 24 vertical pixel arrangement. Then, under control by the controller 40, the column selector 80 selects the pixels 50 of the light-receiving section 60 in units of regions each including, as a unit, 12 pixels in a horizontal direction, that is, 48 (= horizontal 12 × vertical 4) pixels in total, and reads out pixel signals. Here, it is assumed that regions each including 48 pixels as a unit are regions ROI0, ROI1, ROI2, and ROI3, and the region ROI1 among them is a region to be selected. On this occasion, under scanning by the column selector 80, power to each of the pixels 50 of the regions ROI0, ROI2, and ROI3 other than the region ROI1 to be selected is shut off by a switching action of the column selection switch element, that is, the N-type MOS transistor $Q_H$ to turn each of the pixels 50 to an unselected state.

As described above, in a case where the column selector 80 selects the pixels 50, for example, in units of the regions ROI each including 48 pixels (12 horizontal × 4 vertical), and reads out the signals of the pixels 50 for each of the regions ROI, the readout circuit section 90 processes the signals of the pixels 50 for each of the regions ROI (ROI0/ROI1/ROI2/ROI3) selected by the column selector 80. Specifically, a circuit portion of the readout circuit section 90 corresponds to the region ROI selected by the column selector 80, and the readout circuit section 90 is divided into four, that is, a circuit portion 90A, a circuit portion 90B, a circuit portion 90C, and a circuit portion 90D.

Then, the controller 40 controls the readout circuit section 90 to turn a circuit portion (the circuit portion 90B in this example) corresponding to the region ROI selected by the column selector 80 to an activated state and turn the circuit portion 90A, the circuit portion 90C, and the circuit portion 90D other than the circuit portion 90B to an inactivated state. In the readout circuit section 90, a clock system is divided for each of the circuit portions, and a power supply island is also separated, which makes it possible to perform switching of activation/inactivation for each of the circuit portions.

As described above, the readout circuit section 90 according to the example 2 is divided into the circuit portions corresponding to the regions ROI selected by the column selector 80, and under control by the controller 40, the circuit portions other than the circuit portion corresponding to the region ROI selected by the column selector 80 are turned to the inactivated state by turning OFF a clock and turning OFF a power supply. This makes it possible to also achieve power saving in the readout circuit section 90 in addition to power saving in the pixels 50.

[Example 3]

An example 3 is a control example by the controller 40. As described above, the controller 40 performs control of pixel selection by the column selector 80, and readout control of the signals (pixel signals) of the pixels 50 by the readout circuit section 90 on the basis of the synchronization signal S_SYNC, the control signal LD_NUM, the timing signals TRG_I and PRE_TRG, and the selection signal SEL.

The control signal LD_NUM is a signal for determining the division number of the regions RIO to be selected by the column selector 80, and the selection signal SEL is a signal for specifying which region ROI is to be selected to read out the pixel signals. Here, the division number of the regions RIO to be selected by the column selector 80 is the number of the regions ROI including, as a unit, a plurality of pixels in one pixel row or a plurality of pixel rows selected by the column selector 80.

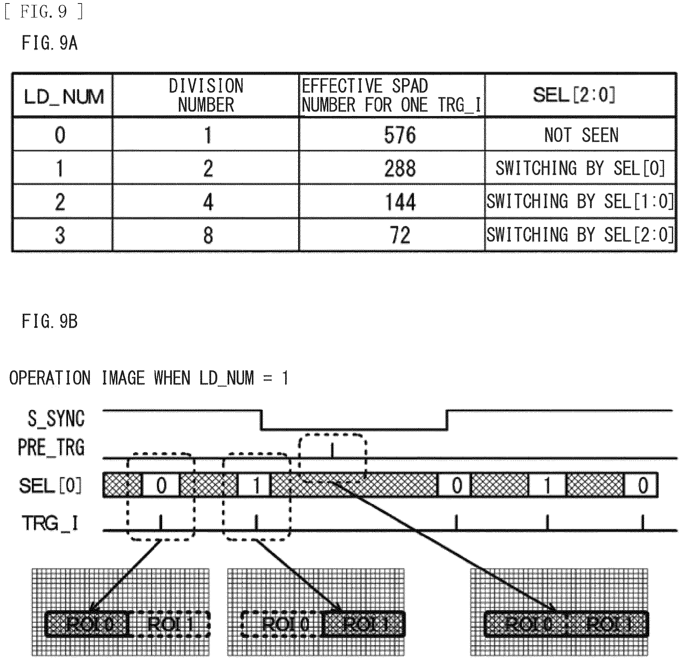

The controller 40 first sets the division number of the region ROI to be selected by the column selector 80 on the basis of the control signal LD_NUM, as illustrated in FIG. 9A. As an example, the division number is set to the division number = 1 (that is, no division) when LD_NUM = 0, the division number = 2 when LD_NUM = 1, the division number = 4 when LD_NUM = 2, and the division number = 8 when LD_NUM = 3. Here, a case where the effective SPAD number for one timing signal TRG I is 576 when LD_NUM = 0, 288 when LD_NUM = 1, 144 when LD_NUM = 2, and 72 when LD_NUM = 3 is exemplified.

FIG. 9B illustrates an operation image when LD_NUM = 1, that is, when the division number = 2. When the division number = 2, the region ROI0 and the region ROI1 are readout regions. Then, the region ROI0 and the region ROI1 are alternately turned to an operation state in synchronization with the timing signal TRG I to perform readout of the signals of the pixels 50. In addition, in order to eliminate an influence of ambient light, an ambient light component is acquired in an entire processing range (the region ROI0 and the region ROI1 in this example) regardless of the division mode of the regions ROI in synchronization with the timing signal PRE_TRG. As for the ambient light component, for example, processing of taking a difference with respect to the pixel signals obtained from the region ROI0 and the region ROI1 is performed in the readout circuit section 90. This makes it possible to eliminate the influence of the ambient light.

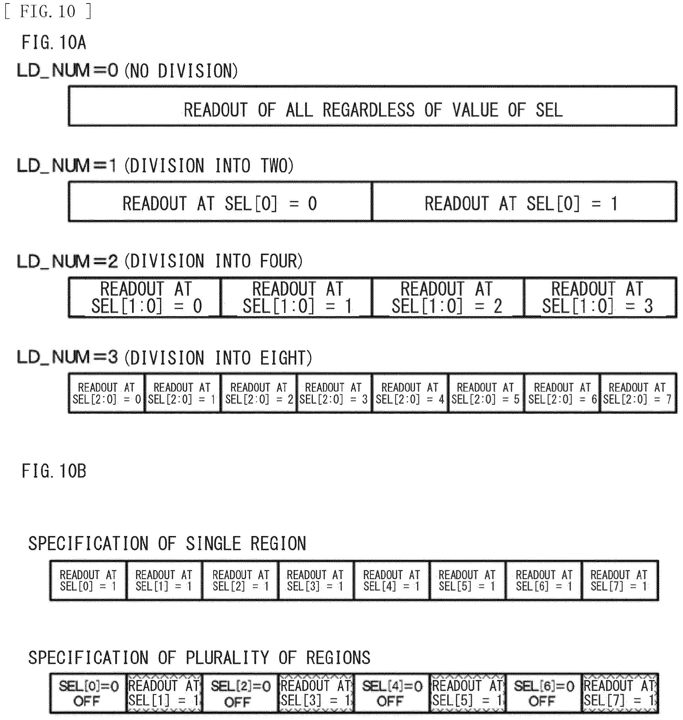

Description is given of an example of setting of the division number of the regions ROI by the control signal LD_NUM and specification of the regions ROI by the selection signal SEL with reference to FIG. 10A.

- · LD_NUM = 0 (no division)

In this division mode, all the pixel signals are read out regardless of the value of the selection signal SEL.

- · LD_NUM = 1 (Division into two: ROI0/ROI1)

In this division mode, readout from the region ROI0 is performed at SEL[0] = 0, and readout from the region ROI1 is performed at SEL[0] = 1.

- · LD_NUM = 2 (Division into four: ROI0/ROI1/ROI2/ROI3)

In this division mode, readout from the region ROI0 is performed at SEL[1:0] = 0, readout from the region ROI1 is performed at SEL[1:0] = 1, readout from the region ROI2 is performed at SEL[1:0] = 2, and readout from the region ROI3 is performed at SEL[1:0] = 3.

- · LD_NUM = 3 (Division into eight: ROI0/ROI1/ROI2/ROI3/ROI4/ROI5/ROI6/ROI7)

In this division mode, readout from the region ROI0 is performed at SEL[2:0] = 0, readout from the region ROI1 is performed at SEL[2:0] = 1, readout from the region ROI2 is performed at SEL[2:0] = 2, readout from the region ROI3 is performed at SEL[2:0] = 3, readout from the region ROI4 is performed at SEL[2:0] = 4, readout from the region ROI5 is performed at SEL[2:0] = 5, readout from the region ROI6 is performed at SEL[2:0] = 6, and readout from the region ROI7 is performed at SEL[2:0] = 7.

In the example described above, the division number of the regions ROI is set by the control signal LD_NUM, and the regions ROI are specified by the selection signal SEL; however, the regions ROI may be specified only by the selection signal SEL. Specifically, as illustrated in an upper stage of FIG. 10B, a single region ROI may be specified only by the selection signal SEL, and as illustrated in a lower stage of FIG. 10B, a plurality of regions ROI may be specified only by the selection signal SEL.

As can seen from the above description, the controller 40 is able to specify the region ROI where the signals of the pixels 50 are to be read out in accordance with a set value of the selection signal SEL. That is, the controller 40 is able to optionally specify a region where the signals of the pixels 50 are to be read out among a plurality of set regions, in accordance with the value of the selection signal SEL.

[Example 4]

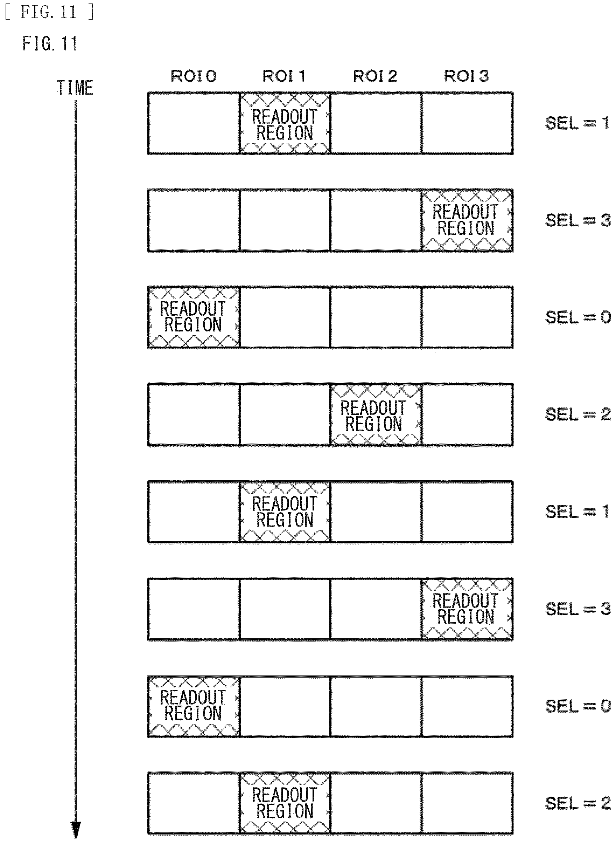

An example 4 is an example in which signals of the regions ROI are read out in a time division manner, and is an example in a division mode of division into four (ROIO/ROI1/ROI2/ROI3). FIG. 11 illustrates an operation example of time-division readout according to the example 4.

In a case of the division mode of division into four, the region ROI0, the region ROI1, the region ROI2, and the region ROI3 are selected in region units, and the signals of the pixels 50 in the selected region ROI are read out. In reading out the signals, the controller 40 reads out the signals of the pixels 50 in one pixel row or a plurality of pixel rows selected by the row selector 70 in a time division manner for each region.

On this occasion, it is preferable that under control by the controller 40, a region away from a previous readout region be set as a present readout region. Specifically, in the division mode of division into four, as illustrated in FIG. 11, the controller 40 first sets the region ROI1 as the readout region, and then skips the region ROI2 and sets, as the readout region, the region ROI3 away from the region ROI1. Next, the controller 40 skips the region ROI1 and the region ROI2 and sets, as the readout region, the region ROI0 away from the region ROI3. Next, the region ROI1 is skipped, and the region ROI2 away from the region ROI00 is set as the readout region.

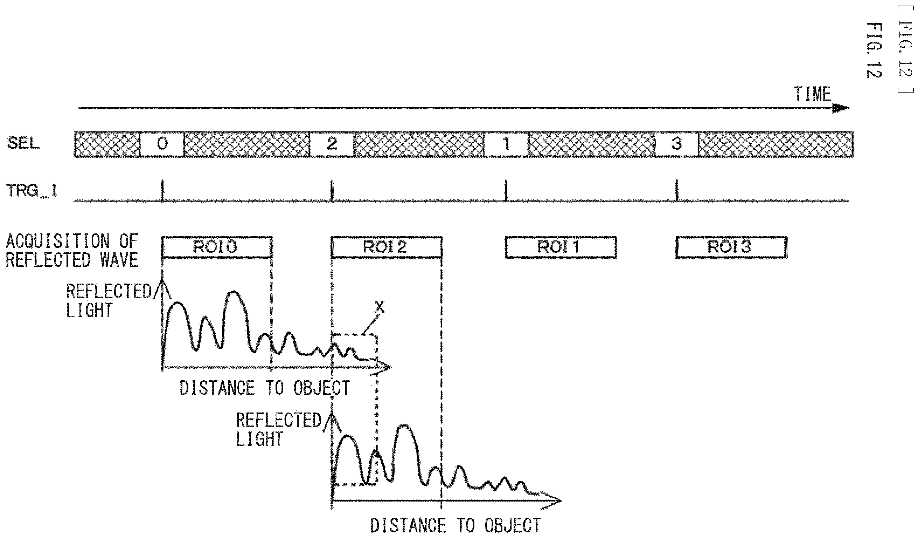

Here, a case is considered where as the readout regions of the pixel signals, adjacent regions are set in order of the region ROI0 $\rightarrow$ the region ROI1 $\rightarrow$ the region ROI2 $\rightarrow$ the region ROI3. In a case where the readout regions of the pixel signals are adjacent to each other in such a manner, light emission of the present readout region starts before reflected light (a reflected wave) of light emitted from the previous readout region is converged; therefore, as indicated by a region X surrounded by a dotted line in FIG. 12, light emission of the present readout region is affected by light emission of the previous readout region. In contrast, as described above, as the present readout region, a region away from the previous readout region is set, which causes an advantage that it is possible to suppress the influence of light emission of the previous readout region in reading out the signals of the pixels 50 in the present readout region.

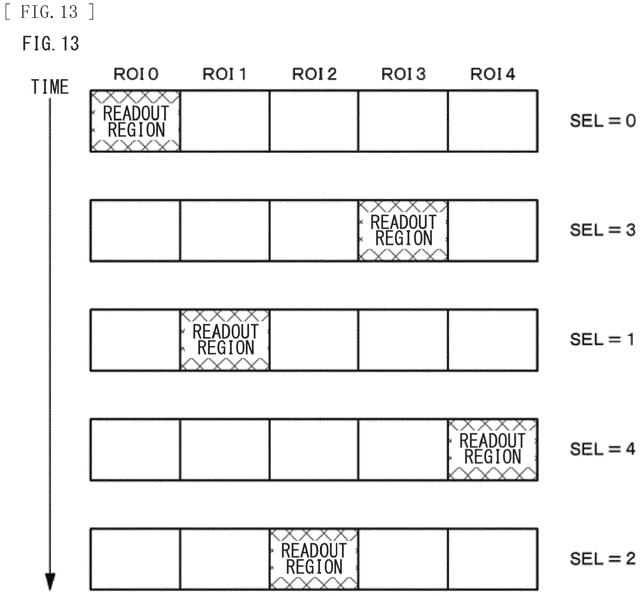

As an example other than the division mode of division into four, for example, an operation example of time division readout in a case of division into five is illustrated in FIG. 13. In a division mode of division into five, for example, the readout regions are set in order of the region ROI0 $\rightarrow$ the region ROI3 $\rightarrow$ the region ROI1 $\rightarrow$ the region ROI4 $\rightarrow$ the region ROI2, and readout is performed in a time division manner for each region, which makes it possible to suppress the influence of light emission of the previous readout region in reading out the signals of the pixels 50 in a presently set region.

[Example 5]

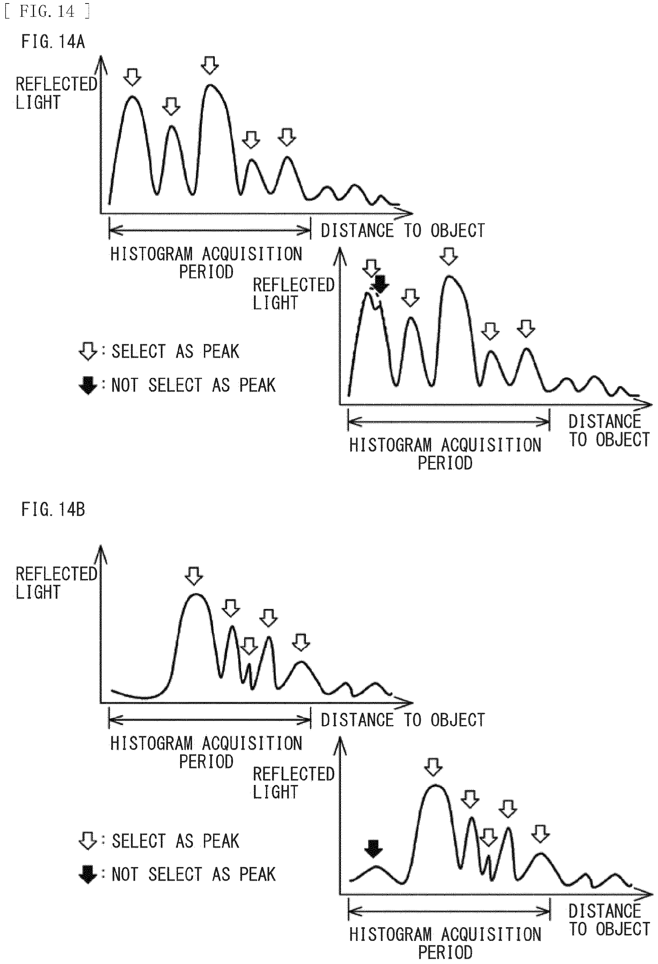

An example 5 is an example in which a peak of a histogram is selected. As described above, in the distance measuring device, the time t is measured by executing time measurement a plurality of times and detecting a peak of a histogram in which times obtained by the plurality of times of measurement are cumulated, and the distance L to a subject is determined on the basis of the time t. FIG. 14A and FIG. 14B each illustrate a specific example of peak selection of the histogram according to the example 5.

FIG. 14A is a waveform diagram in a case where in a present histogram acquisition period, a small peak is generated in a first peak portion by an influence of light emission of a previous readout region. In a case of a specific example illustrated in FIG. 14A, filtering processing or the like is performed not to select (acquire) the small peak caused by the influence of light emission of the previous readout region. FIG. 14B is a waveform diagram in a case where a small peak is generated at a close distance by the influence of light emission of the previous readout region. In a case of a specific example illustrated in FIG. 14B, the small peak at the close distance is not selected (acquired).

According to the specific examples of peak selection of the histogram according to the example 5 illustrated in FIG. 14A and FIG. 14B, it is possible to eliminate the influence of light emission of the previous readout region in the present histogram acquisition period.

<Modification Examples>

Although the technology of the present disclosure has been described with reference to preferred embodiments, the technology of the present disclosure is not limited to the embodiments. The configurations and structures of the light reception device and the distance measuring device described in the above embodiments are illustrative, and may be appropriately modified. For example, in the embodiments described above, a case where the SPAD element is used as the light-receiving element has been described as an example; however, the light-receiving element is not limited to the SPAD element, and even in a case where an element such as an APD and a CAPD is used, similar workings and effects are achievable.

<Application Example of Technology According to Present Disclosure >

The technology according to the present disclosure is applicable to various products. A more specific application example is described below. For example, the technology according to the present disclosure may be achieved in the form of a distance measuring device to be mounted to a mobile body of any kind such as an automobile, an electric vehicle, a hybrid electric vehicle, a motorcycle, a bicycle, a personal mobility, an airplane, a drone, a vessel, a robot, a construction machine, and an agricultural machine (tractor).

[Mobile Body]

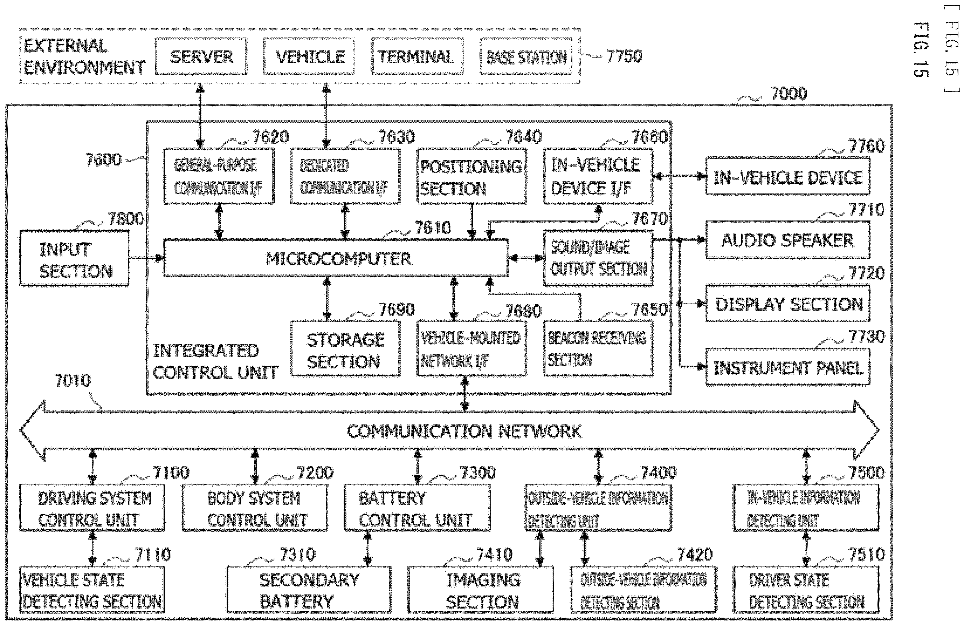

FIG. 15 is a block diagram depicting an example of schematic configuration of a vehicle control system 7000 as an example of a mobile body control system to which the technology according to an embodiment of the present disclosure can be applied. The vehicle control system 7000 includes a plurality of electronic control units connected to each other via a communication network 7010. In the example depicted in FIG. 15, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay, or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in FIG. 15 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

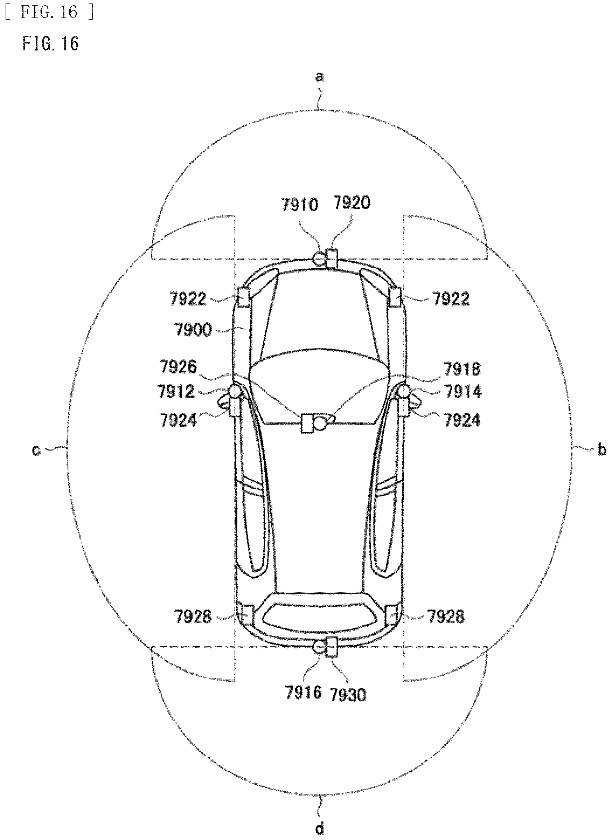

FIG. 16 depicts an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Incidentally, FIG. 16 depicts an example of photographing ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to FIG. 15, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magneto-optical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM), worldwide interoperability for microwave access (WiMAX), long term evolution (LTE)), LTE-advanced (LTE-A), or the like, or another wireless communication protocol such as wireless LAN (referred to also as wireless fidelity (Wi-Fi), Bluetooth, or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth, near field communication (NFC), or wireless universal serial bus (WUSB). In addition, the in-vehicle device I/F 7660 may establish wired connection by universal serial bus (USB), high-definition multimedia interface (HDMI), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automatic driving, which makes the vehicle to travel autonomously without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of FIG. 15, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Incidentally, at least two control units connected to each other via the communication network 7010 in the example depicted in FIG. 15 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

An example of the vehicle control system to which the technology according to the present disclosure is applicable has been described above. In a case where the imaging section 7410 among the configurations described above includes a ToF camera, the technology according to the present disclosure is applicable to the ToF camera. Then, applying the technology according to the present disclosure makes it possible to reduce power consumption in reading out a signal of each of pixels of a light-receiving section, which makes it possible to achieve, for example, a vehicle control system having low power consumption.

<Possible Configurations of Present Disclosure>

It is to be noted that the present disclosure may also have the following configurations.

«A. Light Reception Device»

[A-1] A light reception device including:

a light-receiving section including pixels two-dimensionally arranged in a matrix, the pixels each including a light-receiving element;
a row selector that selects the pixels of the light-receiving section in units of one pixel row or a plurality of pixel rows;
a column selector that selects the pixels in one pixel row or a plurality of pixel rows selected by the row selector in pixel units; and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

[A-2] The light reception device according to [A-1], including a readout circuit section that processes signals read out from the pixels of the light-receiving section, in which
the readout circuit section processes the signals read out from the pixels of the light-receiving section for each region selected by the column selector.
[A-3] The light reception device according to [A-2], in which the controller controls the readout circuit section to turn a circuit portion other than a circuit portion corresponding to the region selected by the column selector to an inactivated state.
[A-4] The light reception device according to any one of [A-1] to [A-3], in which the pixels each include a column selection switch element that turns each pixel to a selected state in response to a scanning signal supplied from the column selector.
[A-5] The light reception device according to [A-4], in which the column selection switch element turns the pixel to an unselected state by turning power to the pixel to a shutoff state.
[A-6] The light reception device according to any one of [A-1] to [A-5], in which the controller is configured to set number of regions each including a plurality of pixels as a unit in the one pixel row or the plurality of pixel rows selected by the row selector.
[A-7] The light reception device according to [A-6], in which the controller is configured to optionally specify a region where signals of pixels are to be read out among a plurality of set regions.
[A-8] The light reception device according to any one of [A-1] to [A-7], in which the controller sets, as a present readout region, a region away from a previous readout region in a case where signals of the pixels in the one pixel row or the plurality of pixel rows selected by the row selector are read out in a time division manner for each region.
[A-9] The light reception device according to any one of [A-1] to [A-8], in which the light-receiving element comprises an element that generates a signal in response to reception of a photon.
[A-10] The light reception device according to [A-9], in which the light-receiving element includes a single-photon avalanche diode.

«B. Distance Measuring Device»

[B-1] A distance measuring device including:

a light source that irradiates a measurement object with light; and
a light reception device that detects light reflected by the measurement object, the light reception device including:

a light-receiving section including pixels two-dimensionally arranged in a matrix, the pixels each including a light-receiving element,
a row selector that selects the pixels of the light-receiving section in units of one pixel row or a plurality of pixel rows,
a column selector that selects the pixels in one pixel row or a plurality of pixel rows selected by the row selector in pixel units, and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

[B-2] The distance measuring device according to [B-1], including a readout circuit section that processes signals read out from the pixels of the light-receiving section, in which
the readout circuit section processes the signals read out from the pixels of the light-receiving section for each region selected by the column selector.
[B-3] The distance measuring device according to [B-2], in which the controller controls the readout circuit section to turn a circuit portion other than a circuit portion corresponding to the region selected by the column selector to an inactivated state.
[B-4] The distance measuring device according to any one of [B-1] to [B-3], in which the pixels each include a column selection switch element that turns each pixel to a selected state in response to a scanning signal supplied from the column selector.
[B-5] The distance measuring device according to [B-4], in which the column selection switch element turns the pixel to an unselected state by turning power to the pixel to a shutoff state.
[B-6] The distance measuring device according to any one of [B-1] to [B-5], in which the controller is configured to set number of regions each including a plurality of pixels as a unit in the one pixel row or the plurality of pixel rows selected by the row selector.
[B-7] The distance measuring device according to [B-6], in which the controller is configured to optionally specify a region where signals of pixels are to be read out among a plurality of set regions.
[B-8] The distance measuring device according to any one of [B-1] to [B-7], in which the controller sets, as a present readout region, a region away from a previous readout region in a case where signals of the pixels in the one pixel row or the plurality of pixel rows selected by the row selector are read out in a time division manner for each region.
[B-9] The distance measuring device according to any one of [B-1] to [B-8], in which the light-receiving element comprises an element that generates a signal in response to reception of a photon.
[B-10] The distance measuring device according to [B-9], in which the light-receiving element includes a single-photon avalanche diode.

Reference Signs List

1 distance measuring device
10 subject (measurement object)
20 light source
21 laser driver
22 laser light source
23 diffusion lens
30 light reception device
31 light-receiving lens
32 optical sensor
33 circuit section
40 controller
50 pixel
51 SPAD element
60 light-receiving section
70 row selector
80 column selector
90 readout circuit section

## Claims

**1.** A light reception device comprising:

a light-receiving section including pixels two-dimensionally arranged in a matrix, the pixels each including a light-receiving element;
a row selector that selects the pixels of the light-receiving section in units of one pixel row or a plurality of pixel rows;

a column selector that selects the pixels in one pixel row or a plurality of pixel rows selected by the row selector in pixel units; and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

**2.** The light reception device according to claim 1, comprising a readout circuit section that processes signals read out from the pixels of the light-receiving section, wherein
the readout circuit section processes the signals read out from the pixels of the light-receiving section for each region selected by the column selector.

**3.** The light reception device according to claim 2, wherein the controller controls the readout circuit section to turn a circuit portion other than a circuit portion corresponding to the region selected by the column selector to an inactivated state.

**4.** The light reception device according to claim 1, wherein the pixels each include a column selection switch element that turns each pixel to a selected state in response to a scanning signal supplied from the column selector.

**5.** The light reception device according to claim 4, wherein the column selection switch element turns the pixel to an unselected state by turning power to the pixel to a shutoff state.

**6.** The light reception device according to claim 1, wherein the controller is configured to set number of regions each including a plurality of pixels as a unit in the one pixel row or the plurality of pixel rows selected by the row selector.

**7.** The light reception device according to claim 6, wherein the controller is configured to optionally specify a region where signals of pixels are to be read out among a plurality of set regions.

**8.** The light reception device according to claim 1, wherein the controller sets, as a present readout region, a region away from a previous readout region in a case where signals of the pixels in the one pixel row or the plurality of pixel rows selected by the row selector are read out in a time division manner for each region.

**9.** The light reception device according to claim 1, wherein the light-receiving element comprises an element that generates a signal in response to reception of a photon.

**10.** The light reception device according to claim 9, wherein the light-receiving element includes a single-photon avalanche diode.

**11.** A method of controlling a light reception device, the light reception device including

a light-receiving section including pixels two-dimensionally arranged in a matrix, the pixels each including a light-receiving element,
a row selector that selects the pixels of the light-receiving section in units of one pixel row or a plurality of pixel rows, and
a column selector that selects the pixels in one pixel row or a plurality of pixel rows selected by the row selector in pixel units,
the method comprising:
in control of the light reception device, controlling the column selector to select the pixels in the one pixel row or the plurality of pixel rows selected by the row selector in units of regions each including a plurality of pixels as a unit, and reading out signals of the pixels for each of the regions.

**12.** A distance measuring device comprising:

a light source that irradiates a measurement object with light; and
a light reception device that detects light reflected by the measurement object, the light reception device including:

a light-receiving section including pixels two-dimensionally arranged in a matrix, the pixels each including a light-receiving element,

a row selector that selects the pixels of the light-receiving section in units of one pixel row or a plurality of pixel rows,
a column selector that selects the pixels in one pixel row or a plurality of pixel rows selected by the row selector in pixel units, and
a controller that controls the column selector,
the controller controlling the column selector to select the pixels in the one pixel row or the plurality of pixel rows selected by the row selector in units of regions each including a plurality of pixels as a unit, and read out signals of the pixels for each of the regions.

[ FIG. 1 ]

FIG. 1
10
SUBJECT
1
30
20

[ FIG. 2 ]

FIG. 2A

1
30
40
33
32
31
LOGIC CIRCUIT
REFLECTED
LASER LIGHT
CONTRO-
LLER
21
22
23
LASER DRIVER
IRRADIATION
LASER LIGHT
20

FIG. 2B

hv
hv
32
33
OPTICAL SENSOR
LOGIC CIRCUIT

[ FIG. 3 ]

FIG. 3
50
POWER SUPPLY
VOLTAGE
V_DD
52
V_DD
~Q_L
~Q_p
V_CA
SPAD OUTPUT
~Q_n
51
~C
54
ANODE
VOLTAGE
V_bd
53

[ FIG. 4 ]

FIG. 4A

CURRENT
OPERATION POINT
OF SPAD ELEMENT
VBD
VOLTAGE
VEX

FIG. 4B

RECHARGE
TIME
CATHODE VOLTAGE
VCA
T
SPAD OUTPUT

[ FIG. 5 ]

[ FIG. 6 ]

FIG. 6

START
SELECT ONE PIXEL ROW OR PLURALITY OF PIXEL ROWS
S11
SELECT PIXELS IN SELECTED ONE PIXEL ROW OR PLURALITY OF PIXEL ROWS IN UNITS OF REGIONS EACH INCLUDING PLURALITY OF PIXELS AS UNIT
S12
READ OUT SIGNALS OF PIXELS FOR EACH SELECTED REGION
S13
END

[ FIG. 7 ]

FIG. 7

O_SPAD
I_OR
59
58
57
50B
56
55
EN_C
EN_F
50
54
50A
$V_{DD}$
$Q_L$
SW
EN_PR
$Q_H$
$Q_V$
XEN_SPAD_V
XEN_SPAD_H
$V_{REF}$
T
$V_{CA}$
$V_{bd}$
51

[ FIG.8 ]

FIG.8

50
60
90
ROI 3
ROI 2
ROI 1
ROI 0
90D
90C
90B
90A

[ FIG. 9 ]

FIG. 9A

| LD_NUM | DIVISION NUMBER | EFFECTIVE SPAD NUMBER FOR ONE TRG_I | SEL[2:0] |
|---|---|---|---|
| 0 | 1 | 576 | NOT SEEN |
| 1 | 2 | 288 | SWITCHING BY SEL[0] |
| 2 | 4 | 144 | SWITCHING BY SEL[1:0] |
| 3 | 8 | 72 | SWITCHING BY SEL[2:0] |

FIG. 9B

OPERATION IMAGE WHEN LD_NUM = 1
S_SYNC
PRE_TRG
SEL[0]
0
1
0
1
0
TRG_I
ROI 0
ROI 1
ROI 0
ROI 1
ROI 0
ROI 1

[ FIG. 10 ]

FIG. 10A

LD_NUM=0 (NO DIVISION)

| READOUT OF ALL REGARDLESS OF VALUE OF SEL |
|---|

LD_NUM=1 (DIVISION INTO TWO)

| READOUT AT SEL[0] = 0 | READOUT AT SEL[0] = 1 |
|---|---|

LD_NUM=2 (DIVISION INTO FOUR)

| READOUT AT SEL[1:0] = 0 | READOUT AT SEL[1:0] = 1 | READOUT AT SEL[1:0] = 2 | READOUT AT SEL[1:0] = 3 |
|---|---|---|---|

LD_NUM=3 (DIVISION INTO EIGHT)

| READOUT AT SEL[2:0] = 0 | READOUT AT SEL[2:0] = 1 | READOUT AT SEL[2:0] = 2 | READOUT AT SEL[2:0] = 3 | READOUT AT SEL[2:0] = 4 | READOUT AT SEL[2:0] = 5 | READOUT AT SEL[2:0] = 6 | READOUT AT SEL[2:0] = 7 |
|---|---|---|---|---|---|---|---|

FIG. 10B

SPECIFICATION OF SINGLE REGION

| READOUT AT SEL[0] = 1 | READOUT AT SEL[1] = 1 | READOUT AT SEL[2] = 1 | READOUT AT SEL[3] = 1 | READOUT AT SEL[4] = 1 | READOUT AT SEL[5] = 1 | READOUT AT SEL[6] = 1 | READOUT AT SEL[7] = 1 |
|---|---|---|---|---|---|---|---|

SPECIFICATION OF PLURALITY OF REGIONS

| SEL[0]=0 OFF | READOUT AT SEL[1] = 1 | SEL[2]=0 OFF | READOUT AT SEL[3] = 1 | SEL[4]=0 OFF | READOUT AT SEL[5] = 1 | SEL[6]=0 OFF | READOUT AT SEL[7] = 1 |
|---|---|---|---|---|---|---|---|

[ FIG. 11 ]

FIG. 11

TIME

ROI 0 ROI 1 ROI 2 ROI 3

READOUT REGION SEL = 1

READOUT REGION SEL = 3

READOUT REGION SEL = 0

READOUT REGION SEL = 2

READOUT REGION SEL = 1

READOUT REGION SEL = 3

READOUT REGION SEL = 0

READOUT REGION SEL = 2

[ FIG. 12 ]

FIG. 12
TIME
SEL
0
2
1
3
TRG_I
ACQUISITION OF REFLECTED WAVE
ROI0
ROI2
ROI1
ROI3
REFLECTED LIGHT
DISTANCE TO OBJECT
X
REFLECTED LIGHT
DISTANCE TO OBJECT

[ FIG. 13 ]

FIG. 13

| TIME | ROI 0 | ROI 1 | ROI 2 | ROI 3 | ROI 4 | |
|---|---|---|---|---|---|---|
| | READOUT REGION | | | | | SEL = 0 |
| | | | | READOUT REGION | | SEL = 3 |
| | | READOUT REGION | | | | SEL = 1 |
| | | | | | READOUT REGION | SEL = 4 |
| | | | READOUT REGION | | | SEL = 2 |

[ FIG. 14 ]

FIG. 14A

REFLECTED LIGHT
DISTANCE TO OBJECT
HISTOGRAM ACQUISITION PERIOD
REFLECTED LIGHT
DISTANCE TO OBJECT
HISTOGRAM ACQUISITION PERIOD
: SELECT AS PEAK
: NOT SELECT AS PEAK

FIG. 14B

REFLECTED LIGHT
DISTANCE TO OBJECT
HISTOGRAM ACQUISITION PERIOD
REFLECTED LIGHT
DISTANCE TO OBJECT
HISTOGRAM ACQUISITION PERIOD
: SELECT AS PEAK
: NOT SELECT AS PEAK

[ FIG. 15 ]

FIG. 15

EXTERNAL ENVIRONMENT
SERVER
VEHICLE
TERMINAL
BASE STATION
7750
7000
7600
7620
GENERAL-PURPOSE COMMUNICATION I/F
7630
DEDICATED COMMUNICATION I/F
7640
POSITIONING SECTION
7660
IN-VEHICLE DEVICE I/F
7760
IN-VEHICLE DEVICE
7800
INPUT SECTION
7610
MICROCOMPUTER
7670
SOUND/IMAGE OUTPUT SECTION
7710
AUDIO SPEAKER
7720
DISPLAY SECTION
7690
STORAGE SECTION
7680
VEHICLE-MOUNTED NETWORK I/F
7650
BEACON RECEIVING SECTION
7730
INSTRUMENT PANEL
INTEGRATED CONTROL UNIT
7010
COMMUNICATION NETWORK
7100
DRIVING SYSTEM CONTROL UNIT
7200
BODY SYSTEM CONTROL UNIT
7300
BATTERY CONTROL UNIT
7400
OUTSIDE-VEHICLE INFORMATION DETECTING UNIT
7500
IN-VEHICLE INFORMATION DETECTING UNIT
7110
VEHICLE STATE DETECTING SECTION
7310
SECONDARY BATTERY
7410
IMAGING SECTION
7420
OUTSIDE-VEHICLE INFORMATION DETECTING SECTION
7510
DRIVER STATE DETECTING SECTION

[ FIG. 16 ]

FIG. 16
a
7910 7920
7922
7922
7900
7926
7918
7912
7914
7924
7924
c
b
7928
7928
7916 7930
d

## INTERNATIONAL SEARCH REPORT

International application No. PCT/JP2020/023703

A. CLASSIFICATION OF SUBJECT MATTER
Int. Cl. G01S7/4861(2020.01)i, G01C3/06(2006.01)i, G01S17/10(2020.01)i, H01L27/146(2006.01)i, H04N5/345(2011.01)i
FI: G01S7/4861, G01S17/10, G01G3/06 120Q, H04N5/345, H01L27/146 A
According to International Patent Classification (IPC) or to both national classification and IPC

B. FIELDS SEARCHED

Minimum documentation searched (classification system followed by classification symbols)
Int. Cl. G01S7/48-7/51, G01S17/00-17/95, G01C3/00-3/32, H04N3/00-3/378, H01L27/142-27/148

Documentation searched other than minimum documentation to the extent that such documents are included in the fields searched
Published examined utility model applications of Japan 1922-1996
Published unexamined utility model applications of Japan 1971-2020
Registered utility model specifications of Japan 1996-2020
Published registered utility model applications of Japan 1994-2020

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2019/049923 A1 (SONY SEMICONDUCTOR SOLUTIONS CORPORATION) 14 March 2019, claims, paragraphs [0008], [0018]-[0073], [0150]-[0173], fig. 1-8, 20-23 | 1-3, 9, 11<br>4-7, 10, 12<br>8 |
| Y | JP 2019-518200 A (QUALCOMM INC.) 27 June 2019, claims, paragraphs [0012]-[0037], fig. 1-5 | 4-5, 10, 12 |
| Y | JP 2018-085099 A (SAMSUNG ELECTRONICS CO., LTD.) 31 May 2018, claims, paragraphs [0002], [0027]-[0062], [0067], [0068], [0077], fig. 1-8, 11 | 4-5 |
| Y | JP 2013-090074 A (SONY CORP.) 13 May 2013, claims, paragraphs [0063]-[0066], fig. 6, 7, lines 1-12 | 6-7 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04.08.2020 | 18.08.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/023703

C (Continuation). DOCUMENTS CONSIDERED TO BE RELEVANT

| Category* | Citation of document, with indication, where appropriate, of the relevant passages | Relevant to claim No. |
|---|---|---|
| A | JP 2019-032305 A (FOND BRUNO KESSLER) 28 February 2019, entire text, all drawings | 1-12 |
| A | WO 2019/012756 A1 (SONY SEMICONDUCTOR SOLUTIONS CORPORATION) 17 January 2019, entire text, all drawings | 1-12 |

Form PCT/ISA/210 (continuation of second sheet) (January 2015)

**INTERNATIONAL SEARCH REPORT**
Information on patent family members

International application No.
PCT/JP2020/023703

| Patent Documents referred to in the Report | Publication Date | Patent Family | Publication Date |
|---|---|---|---|
| WO 2019/049923 A1 | 14.03.2019 | (Family: none) | |
| JP 2019-518200 A | 27.06.2019 | US 2017/0301716 A1 claims, paragraphs [0015]-[0040], fig. 1-5<br>WO 2017/180277 A1<br>EP 3443377 B1<br>CA 3017223 A1<br>KR 10-2018-0115799 A<br>CN 108885251 A<br>BR 112018071077 A | |
| JP 2018-085099 A | 31.05.2018 | US 2018/0143701 A1 claims, paragraphs [0003], [0025]-[0060], [0065], [0066], [0075], fig. 1-8, 11<br>EP 3324613 A1<br>KR 10-2018-0056962 A<br>CN 108089697 A | |
| JP 2013-090074 A | 13.05.2013 | (Family: none) | |
| JP 2019-032305 A | 28.02.2019 | US 2019/0018117 A1 entire text, all drawings<br>EP 3428683 A1<br>CN 109239694 A | |
| WO 2019/012756 A1 | 17.01.2019 | CN 110832346 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016211881 A